# EUROPEAN PATENT SPECIFICATION

(11) **EP 2 810 312 B1**
(45) Date of publication and mention of the grant of the patent: **09.12.2015**
(21) Application number: 13702372.7
(22) Date of filing: 18.01.2013
(51) Int. Cl.: H01L 39/14, H01F 6/00, H01H 33/00

(54) **A MECHANICAL SUPERCONDUCTING SWITCH**
MECHANISCHER SUPRALEITENDER SCHALTER
COMMUTATEUR SUPRACONDUCTEUR MÉCANIQUE

(30) Priority: 02.02.2012 GB 201201818
(43) Date of publication of application: 10.12.2014
(73) Proprietor: Siemens PLC., Camberley, Surrey GU16 8QD (GB)
(72) Inventor: LAKRIMI, M'Hamed, Oxford, Oxfordshire OX3 0HP (GB); THOMAS, Adrian, Mark, Bicester, Oxfordshire OX26 4FF (GB)
(74) Representative: Maier, Daniel Oliver
(86) International application number: PCT/EP2013/050992
(87) International publication number: WO 2013/113573

(56) References cited:
- GB-A- 1 147 669
- GB-A- 1 174 878
- GB-A- 1 581 969
- US-A- 3 551 861
- US-A- 5 982 179
- US-B1- 6 211 479
- US-B1- 6 677 751
- J. D. SIEGWARTH: "A Mechanical Superconducting Switch for Low Temperature Instrumentation", REVIEW OF SCIENTIFIC INSTRUMENTS, vol. 43, no. 1, 1 January 1972 (1972-01-01), pages 153-154, XP055059229, ISSN: 0034-6748, DOI: 10.1063/1.1685422
- T. KOTOWSKI ET AL: "Superconducting multicontact rotary switch", REVIEW OF SCIENTIFIC INSTRUMENTS, vol. 49, no. 9, 1 January 1978 (1978-01-01), pages 1363-1365, XP055059232, ISSN: 0034-6748, DOI: 10.1063/1.1135564

## Description

Superconducting MRI magnets are formed of several coils of superconducting wire electrically connected in series and conventionally housed within a cryostat with a cryogenic refrigerator which cools the magnet to below a superconducting transition temperature of the material of the coils.

Many conventional designs include a bath of liquid cryogen, for example liquid helium, which is maintained below its boiling point by a cryogenic refrigerator.

However, more recent designs have sought to reduce or eliminate consumption of cryogens such as helium, for example by using cooling loops or "dry" also referred to as cryogen free magnets in which no liquid cryogen is used.

It is necessary to provide a switch across the terminals of the series connection of coils. In one state (the "on" state), the switch should be superconducting, so as to complete a superconducting circuit through the coils so that current may flow persistently in the magnet. In another state (the "off" state), the switch should be resistive, to allow current to be introduced into, or removed from, the coils by a power supply unit connected to the magnet for the purpose. Conventionally, all superconducting switches require the fabrication of an ancillary superconducting coil used to effect the switching operation. The ancillary coil is typically formed of wire having a matrix typically made of a resistive CuNi alloy. This renders the switch susceptible to temperature and wire instabilities. The wire and filament size play an important role in the stability of the switch against flux jumping, in which a small quench in a single filament may propagate to the other filaments in the wire due to resistive dissipation in the matrix material carrying current between filaments.

Conventional superconducting switches have a limited open-circuit resistance and thus limit the achievable ramp rate and dissipate heat during energisation and de-energisation of the magnet. The conventional switches are opened and closed using a thermal heater in thermal contact with the ancillary superconducting coil. This heater contributes to heat load on the cryostat and heat dissipation. For example, a certain conventional design includes an ancillary coil with an "off" resistance of about 5-50 Ω. This dissipates power during ramp up and during ramp down. The heaters themselves on the switch dissipate further energy during a ramp up or down. Such levels of heating are far in excess of the cooling power of a typical 4.2K cryogenic refrigerator. In cryostats with baths of liquid cryogen, the required cooling was provided by immersing the switch in the liquid bath.

The drive for dry magnets calls for a different approach to the superconducting switch as the cooling power at 4.2K is very limited, typically 1.2W.

The following documents contain technical information relating to the background of the present invention:
Makoto Takayasu, Electric Characteristics of Contact Junctions Between NbTi Multifilamentary Wires, IEEE Transactions on Applied Superconductivity, Vol. 9, No. 3, September 1999.
Makoto Takayasu, Toshiaki Matsui, and Joseph V. Minervini, Negative-Resistance Voltage-Current Characteristics of Superconductor Contact Junctions for Macro-Scale Applications, IEEE Transactions on Applied Superconductivity, Vol. 13, No. 2, June 2003.
S. Ohtsuka, H. Ohtsubo, T. Nakamura, J. Suehiro, and M. Hara, Characteristics of NbTi mechanical persistent current switch and mechanism of superconducting connection at contact, Cryogenics 38 (1998) 1441-1444.
US2002/0190824 A1, dated Dec 19, 2002: Persistent Current switch and method for the same.
JP7231125-A, CHODENDO MAGNET KK (CHOD-C); FURUKAWA ELECTRIC CO LTD (FURU-S)1995-08-29, Persistent current switch examination method e.g. for magnetic-levitation train - involves letting circumference current and DC current flow along same direction to persistent current switch by second power supply lifted to both ends.
JP6350148-A, 1994-12-22, HITACHI LTD (HITA-S) Persistent current superconductive device for energy storage - incorporates superconducting wire, current lead and permanent current mechanical switch.
US 5,532,638, dated Jul 2, 1996, CHUBU DENRYOKU KK (CHUB-S); CHUBU ELECTRIC POWER CO (CHUB-S); HITACHI LTD (HITA-S), Superconductive energy storage device for the same.
E M Pavaõ Critical Temperatures of Superconducting Solders. MIT. June 2007
CN100595856C. Chinese Academy of Science.

Further related art is disclosed by US 3 551 861, GB 1 147 669, US 5 982 179, US 6 677 751 B1, GB 1 174 878, US 6 211 479 B1, GB 1 581 969; J. Siegwarth et al., "A Mechanical Superconducting Switch for Low Temperature Instrumentation", Rev. Sci. Instrum., vol. 43, p. 153-154, (1972) and T. Kotowski et al., "Superconducting multicontact rotary switch", Rev. Sci. Instrum., vol. 49, p. 1363-1365, (1978).

The present invention accordingly addresses the above-mentioned problems, and aims to provide a superconducting switch for use with a superconducting magnet which does not suffer from the problems of high heat dissipation and limited "off" resistance.

Accordingly, the present invention provides apparatus as defined in the appended claims.

The above, and further, objects, characteristics and advantages of the invention will become more apparent from the following description of certain examples thereof, given by way of examples only, together with the accompanying drawings, wherein:
Fig. 1 shows an example of a linearly-actuated mechanical superconducting switch according to the present invention;
Figs. 2-5 show alternative types of blocks with contact surfaces, blochs which are cast according to the claims being embodiments of the present invention;
Figs. 6-7 show an example of a rotary-actuated mechanical superconducting switch according to the present invention, wherein Fig. 6 shows a partially cut-away cross section along line VI-VI in Fig. 7.

According to the present invention, no separate ancillary coil is required for the superconducting switch. Instead, the switch is made using wire ends of the coils forming the superconducting magnet itself. The switch of the present invention provides mechanically operating switch contacts to provide electrical conduction between the wire ends of the coils forming the superconducting magnet itself.

The superconducting wire used for the magnet coils typically has a copper matrix and thus offer better stability than CuNi matrix wires typical of conventional superconductor switches.

The switch opening and closing states uses a mechanical action and thus does not require a thermal heater and can have a practically infinite "off" resistance. This minimises any heat dissipation and increases the achievable ramp rate for energising and de-energising the magnet. The cooling power of the cryogenic refrigerator is accordingly available for cooling the magnet and compensating for other thermal loads on the magnet.

In an example, the mechanical superconducting switch of the present invention may be constructed as follows.

The leadout wire from the "start" of the magnet coils is jointed onto itself or to another superconductor. By "jointed onto itself" is meant that superconducting filaments in the wire are exposed, are twisted, plaited or otherwise retained together and then treated as if a joint were being made to another superconducting wire, but only involving this single wire. In an example process, the filaments are tined with indium. Similarly, the leadout wire from the "end" of the magnet coils is also jointed onto itself. Optionally, another piece of superconducting wire may be interposed between the coil "start" or "end" and the joint.

The end of each leadout wire is then placed in a respective mould. BiPb or similar superconducting material with tolerable melting point is then poured into the mould, to form a block of superconducting material on the end of each leadout wire. The mechanical switch of the present invention operates by pressing these blocks into physical contact, and physically separating them. When the two blocks are brought together then the switch is closed and persistence of the magnet can be achieved, at an appropriate temperature. When the blocks are separated from one another, the switch is open and thus enabling energisation or de-energisation of the magnet.

According to an aspect of the present invention, the wires forming the start and end of the magnet are used to form the switch, or at least, wires of conventional construction are used. These wires are optimised for stability and performance and typically have a copper matrix which makes them very stable. The switch of the present invention avoids the need for special wire to manufacture a superconducting switch and relies on proven jointing technology.

Operation of switches according to the present invention has been demonstrated. In an example, a clamping torque of a few Newton-metres was used to press together BiPb blocks each containing NbTi filaments in a copper matrix. Persistence was demonstrated to better than 10⁻¹³Ω at 1000A and under 1.2T background field. This result is more than sufficient for use as superconducting switch in many conventional magnet arrangements. In other tests, with the clamping force only finger tight, persistence to better than 10⁻¹³Ω was achieved at 300A at 0T and 50A under 0.8T background field.

This is seen to be far superior to the result achieved by S. Ohtsuka, H. Ohtsubo, T. Nakamura, J. Suehiro, and M. Hara, Characteristics of NbTi mechanical persistent current switch and mechanism of superconducting connection at contact, Cryogenics 38 (1998) 1441-1444*.* There, in 0T background field, using NbTi blocks, the authors achieved at best 20A with a resistance of 10⁻⁹Ω. With a contact resistance of 1mΩ, the authors achieved 200A with a pressing force of greater than 400N.

An external control arrangement will be required to control the opening of the switch, which will be positioned within the cryostat with the magnet. Control will need to be exercisable from outside the cryostat. Preferably, an electrically operated mechanism is used, with sealed current lead-throughs of conventional construction carrying the control signals into the cryostat. Alternatively, mechanical, hydraulic, pneumatic or piezoelectric arrangements, and similar, may be used.

The present invention accordingly provides a mechanically operated superconductor switch in which contacts are pressed together for producing a persistent circuit in superconducting devices, especially magnets. Preferably, at least one of the contacts is formed using a ductile superconducting material, such as BiPb, NbTi, Nb chemically or metallurgically joined to the main superconducting wire to be switched. The superconducting wire to be switched may itself include superconducting filaments of any suitable material, such as NbTi, Nb₃Sn, MgB₂, or high temperature superconductors.

The contacts, or at least the contact surfaces, may be housed in a vacuum or inert atmosphere to preserve surface conditions. The vacuum or inert atmosphere may be the operating environment of the magnet, or separately enclosed, preferably protecting contacts from contamination from the point of manufacture. A chemical getter such as carbon may be incorporated into the enclosure to aid preservation of the atmosphere.

A number of specific arrangements will now be discussed, with reference to the accompanying drawings.

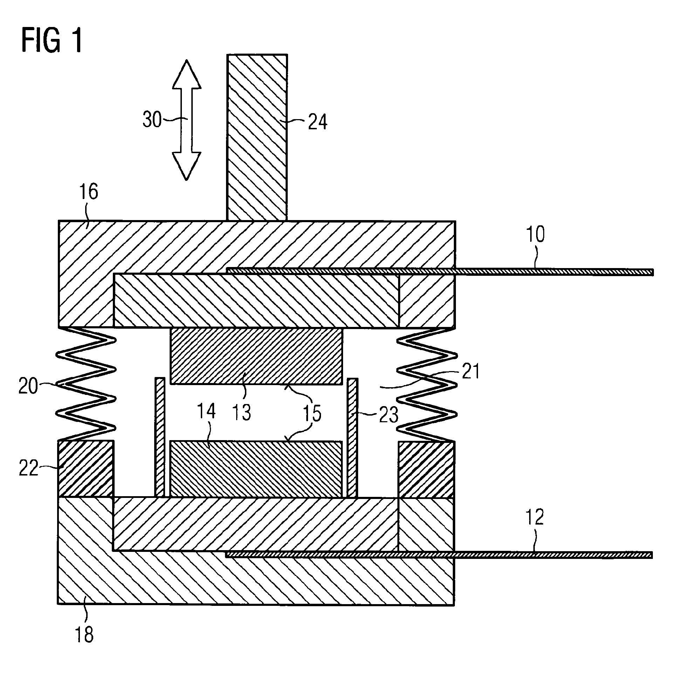

Fig. 1 shows a first example, in which superconducting wires 10, 12 are each embedded within upper 13 and lower 14 blocks of superconducting material, providing contact surfaces 15. Preferably, the material of at least one of the blocks is a ductile superconducting material, such as BiPb, NbTi, Nb. Upper 16 and lower 18 enclosure pieces retain the blocks and a bellows 20 provides a sealed enclosure 21 of variable height. An electrical insulator 22 may be provided if necessary, forming part of the enclosure, to prevent electrical conduction between the wires 10, 12 through the material of the enclosure. Mechanical actuation 30 may drive the contact surfaces 15 into electrical contact and separate them again. Although a mechanical actuator 24 is schematically illustrated, any appropriate means may be used to drive the two enclosure pieces 16, 18 toward one another and apart again to provide closing and opening of the switch. For example, a gas at a certain pressure may be sealed within enclosure 21, the enclosure itself being positioned within another vessel, which may contain gas at a pressure higher or lower than the certain pressure, in order to drive the contact surfaces 15 together or apart. An alignment tube 23 of electrically insulating material may be provided to guide upper 13 and lower 14 blocks into aligned contact with one another.

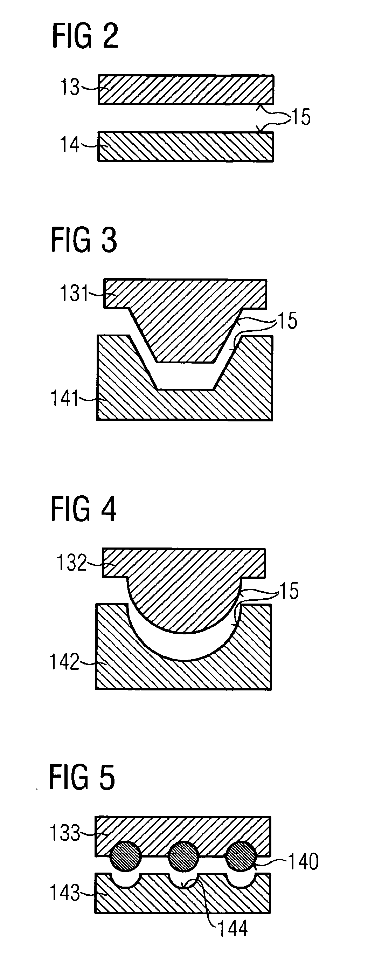

Fig. 2 shows the upper 13 and lower 14 blocks of superconducting material, providing contact surfaces 15, in isolation.

Fig. 3 shows a cross-section through a set of alternative upper 131 and lower 141 blocks of superconducting material. In this example, complementary frusto-conical protrusions and recesses are provided on respective contact surfaces 15. If a force acting in the direction of arrow 30 is applied, the pressure acting between the conical contact surfaces will be rather higher than would be the case with planar contact surfaces, improving the electrical characteristics of the switch in its "on" position.

Fig. 4 shows a cross-section through a set of alternative upper 132 and lower 142 blocks of superconducting material. In this example, complementary part-spherical protrusions and recesses are provided on respective contact surfaces 15. If a force acting in the direction of arrow 30 is applied, the pressure acting between the part-spherical contact surfaces will be rather higher in certain places than would be the case with planar contact surfaces, improving the electrical characteristics of the switch in its "on" position. Other shapes of complementary recesses and protrusions may be provided as appropriate.

Fig. 5 shows a cross-section through a set of alternative upper 133 and lower 143 blocks of superconducting material. In this example, particles or beads 140 of a relatively hard superconducting material are included in at least one of the blocks 133. When blocks 133 and 143 are pressed together, for example by a force operating in the direction of arrow 30, these particles or beads 140 press into the more resilient material of the other block 143 producing corresponding cavities 144. The very high pressure acting at the points of contact between particles or beads 140 and block 143 ensures effective electrical contact.

Other similar arrangements may be devised by those skilled in the art, using the linear actuation arrangement shown in Figs. 1-5.

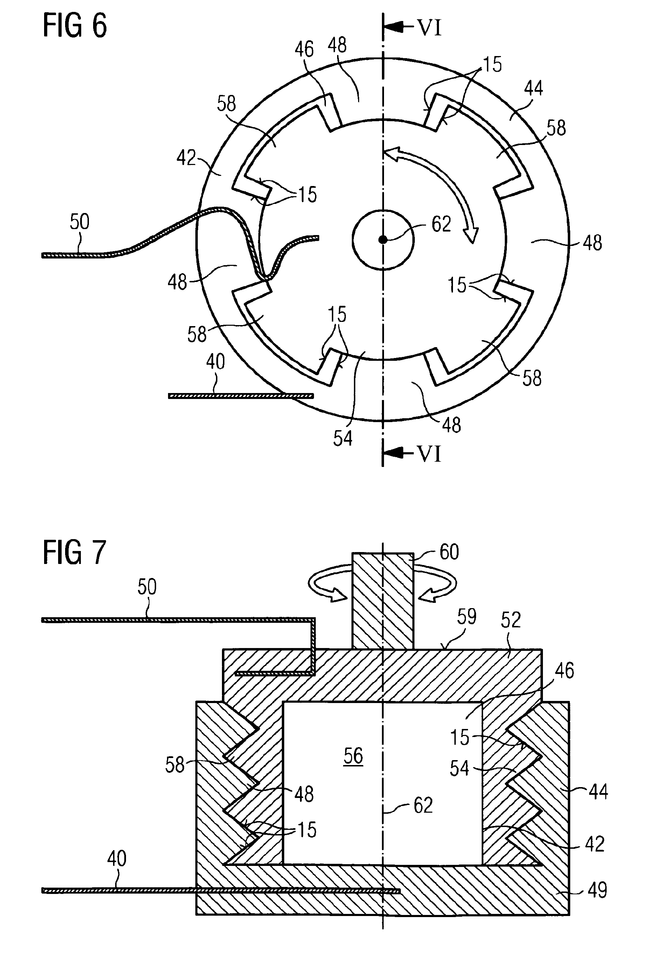

Fig. 6 illustrates another type of embodiment, in which rotational actuation may be employed. In this embodiment, a first superconducting wire 40 is embedded in a first block 42 of superconducting material. This block is of relatively complex shape, having an essentially cylindrical wall 44 with an essentially cylindrical cavity 46 contained therein. At least one protrusion 48 is provided on the wall of the cavity. A closed end 49 may be provided. A second superconducting wire 50 is embedded in a second block 52 of superconducting material. This second block is also of relatively complex shape, having an essentially cylindrical wall 54 which may have an essentially cylindrical cavity 56 contained therein, or may be solid. At least one protrusion 58 is provided on the wall 54. A closed end 59 may be provided. The second block is at least partially located within the cavity of the first block, such that respective protrusions (48, 58) overlap in a circumferential direction.

An actuator 60 may be provided on one or other, or both, of the first and second blocks 42, 52, for rotating one with respect to the other about an axis 62 aligned with the axes of the cylindrical walls of the first and second blocks. Preferably, the first block 42 has a number of protrusions 48 equal to the number of protrusions 58 on the second block.

The mechanical switch of this embodiment is actuated by relative rotation of the two blocks about axis 62. In the position illustrated, the two blocks are held apart, and are not in electrical contact. By driving one or other, or both, of the blocks with respect to each other about axis 62, at least one of the protrusions 58 on the second block is driven into mechanical and electrical contact with a corresponding protrusion 48 on the first block, placing the switch in its "on" position. By relative rotation about axis 62 in the opposite sense, the protrusions are separated from one another again and the switch enters its "off state". A vacuum or inert atmosphere is preferably provided around the blocks. The blocks may be driven about the axis 62 by any suitable means: electromechanical, mechanical, hydraulic, pneumatic or piezoelectric, for example.

Optionally, certain faces of the protrusions of one or both of the blocks 42, 52 may be covered with an electrically isolating layer. Accordingly, the blocks may be driven to the fullest extent about axis 62 in one direction to close the switch, and may be driven to the fullest extent in the opposite direction to open the switch, if electrically isolating layers are provided to prevent any contact between the protrusions of the two blocks when driven in this opposite direction.

In an alternative arrangement, rather than protrusions 48, 58 running parallel to the axis 62, contact surfaces between first and second blocks may be provided by complementary thread surfaces of a helical or conical screw. Fig. 7 illustrates a cross-section along line VI-VI of an embodiment wherein the protrusions 48, 58 on first and second blocks are threaded. These thread surfaces are segmented to give make-break operation with limited rotation, similar to the operation discussed with reference to Fig. 6. The thread may be tapered to ensure limited rotation and tight fit between the two blocks in the embodiment illustrated in Fig. 7. Adjacent thread surfaces 15 may be brought to bear upon one another to provide electrical contact between the blocks, and the blocks may be rotated in the opposite relative direction to separate the blocks, and place the switch in its "off" state.

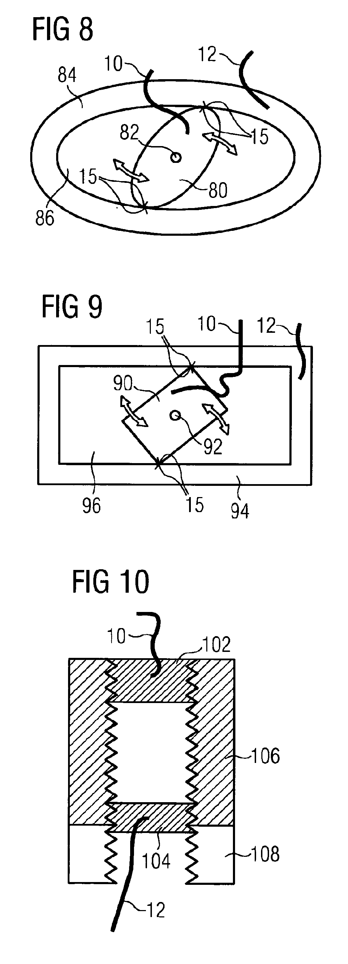

In another set of embodiments, such as illustrated in Fig. 8, first block 80 is arranged to rotate about an axis 82 defined within a cavity of second block 84. In this embodiment both block 80 and cavity 86 are elliptical in cross-section. By rotating block 80 about axis 82, surfaces 15 of the block and cavity may be brought into electrical contact and may be separated by rotation in the opposite direction. Other embodiments, such as shown in Fig. 9 operate in a similar manner. It is not necessary for the block in the cavity to be oval in cross-section. The embodiment of Fig. 9 shows an example in which both the block and the cavity have rectangular cross-sections. Combinations of cross sections may be used, provided that the block has limited scope from rotation into and out of contact with the walls of the cavity.

Fig. 10 shows an example of a further type of embodiment of the invention. Here, blocks 102, 104 remain stationary with respect to one another and a threaded superconducting collar 106 is provided and may be driven in and out of contact between the two blocks by relative rotation. Preferably an electrically isolating extension 108 is provided such that mechanical alignment is ensured when the collar is rotated out of electrical contact between the blocks. This embodiment is an example of another series of embodiments in which the blocks themselves do not move and a connecting superconducting article is moved into and out of contact between the two blocks. Variants of this embodiment will be apparent to those skilled in the art.

In certain embodiments, the improvements discussed with respect to Figs. 3-5 may be applied. Contact surfaces 15 are shown in Figs. 6-10, and these may be improved by the provision of frusto-conical recesses and protrusions, as discussed with reference to Fig. 3, or part-spherical recesses and protrusions as discussed with reference to Fig. 4.

Particles or beads 140 of a relatively hard superconducting material may be included in one of the blocks 42, 52, as discussed with reference to Fig. 5. The very high pressure acting at the points of contact between particles or beads 140 and the other block ensures effective electrical contact. Other types of composite mixture of materials of different hardness may be used, to enable point contact deformation to occur.

During operation, additional mechanical actuation in the form of vibration may be applied to improve contact between the blocks of superconducting material.

To address the issue of possible high-voltage damage caused by switching a high current through a large inductive load using a mechanical switch, a suitable type of semiconductor based snubber is preferably provided to protect against damage.

In each case, the mechanical superconducting switch of the present invention is preferably cooled by the same cooling arrangement used to cool the magnet. Alternatively, a separate cooling arrangement may be provided to cool the switch.

Those skilled in the art will appreciate that the materials mentioned herein are given by way of example only, and other materials with appropriate physical properties may be used. Alternative mechanical arrangements for the switch may also be provided, within the scope of the appended claims.

## Claims

1. A mechanically operating superconducting switch comprising two superconducting wires (10, 12), a respective end of each superconducting wire being cast in a respective block (13, 14; 42, 52) of superconducting material and a mechanical arrangement (24, 16, 18, 20; 60) for driving respective contact surfaces (15) of the two blocks into physical contact with one another, and for separating them.

2. A mechanically operating superconducting switch according to claim 1 wherein the superconducting wires are ends of coils forming a superconducting magnet.

3. A mechanically operating superconducting switch according to claim 1 wherein the mechanical arrangement provides linear actuation for driving the two blocks into mechanical contact with one another, and for separating them.

4. A mechanically operating superconducting switch according to claim 1 wherein the mechanical arrangement provides rotary actuation for driving the two blocks into mechanical contact with one another, and for separating them.

5. A mechanically operating superconducting switch according to any preceding claim, wherein at least one of the blocks is formed using a casting method in which a corresponding superconducting wire is cast into a block of superconducting material, the superconducting material of the at least one block having a ductility greater than a ductility of the superconducting material of the superconducting wire.

6. A mechanically operating superconducting switch according to any preceding claim, wherein complementary protrusions and recesses are provided on respective contact surfaces (15).

7. A mechanically operating superconducting switch according to any preceding claim, wherein at least one of the blocks contains particles or beads (140) of a superconducting material having a hardness greater than a hardness of the material of the corresponding block.

8. A mechanically operating superconducting switch according to any preceding claim, further provided with a control arrangement for controlling the opening and closing of the switch.

9. A mechanically operating superconducting switch according to claim 3, wherein upper (16) and lower (18) enclosure pieces retain respective blocks, and a bellows (20) connects the' upper and lower enclosure pieces to provide a sealed enclosure (22) of variable height.

10. A mechanically operating superconducting switch according to claim 9, wherein an electrical insulator (22) is provided, forming part of the enclosure, to prevent electrical conduction between the wires (10, 12) through the material of the enclosure.

11. A mechanically operating superconducting switch according to claim 4, wherein:
- a first (42) of said blocks has an essentially cylindrical wall (44) with an essentially cylindrical cavity (46) contained therein, and at least one protrusion (48) is provided on a wall of the cavity;
- a second (52) of said blocks has an essentially cylindrical wall (54), and at least one protrusion (58) is provided on the wall;
- the second block is at least partially located within the cavity of the first block, such that respective protrusions (48; 58) overlap in a circumferential direction; and
- the mechanical arrangement comprises means (60) for rotating one block (42; 52) with respect to the other about an axis (62) aligned with the axes of the cylindrical walls of the first and second blocks.

12. A mechanically operating superconducting switch according to claim 11, wherein the first block (42) has a number of protrusions (48) equal to the number of protrusions (58) on the second block.

13. A mechanically operating superconducting switch according to claim 11 or claim 12, wherein certain faces of the protrusions of one or both of the blocks (42, 52) are covered with an electrically isolating layer.

14. A mechanically operating superconducting switch according to any of claims 11 - 13, wherein the protrusions (48; 58) run parallel to the axis (62).

15. A mechanically operating superconducting switch according to any of claims 11 - 13, wherein the protrusions are formed as complementary thread surfaces of a helical or conical screw.

16. A mechanically operating superconducting switch according to claim 15, wherein the thread surfaces are segmented.

17. A mechanically operating superconducting switch according to any preceding claim, provided with a vacuum or inert atmosphere around the blocks.

18. A mechanically operating superconducting switch according to any preceding claim, wherein arrangements are provided for additional mechanical actuation of the blocks in use, in the form of vibration.

19. A mechanically operating superconducting switch according to claim 4, wherein:
- a first (84; 94) of said blocks has a cavity (86; 96) contained therein;
- a second (80; 90) of said blocks is at least partially located within the cavity of the first block, arranged to rotate within the cavity about an axis (82; 92); and
- the mechanical arrangement comprises means for rotating one block (80; 90) with respect to the other about the axis.

20. A mechanically operating superconducting switch comprising two superconducting wires (10, 12), a respective end of each superconducting wire being cast in a respective block (102, 104) of superconducting material, wherein, in use, the blocks (102, 104) remain stationary with respect to one another and a threaded superconducting collar (106) is driven in and out of contact between the two blocks by relative rotation.

21. A mechanically operating superconducting switch according to claim 20 wherein an electrically isolating extension (108) of the threaded superconducting collar is provided, such that mechanical alignment of the blocks (102, 104) is ensured when the collar is rotated out of electrical contact between the blocks.

22. A superconducting magnet structure comprising a plurality of coils of superconducting wire electrically connected in series, housed within a cryostat arranged to cool the coils, **characterized in that** superconducting wires from electrical ends of the coils are connected to a switch according to any preceding claim.

23. A superconducting magnet structure according to claim 22, wherein the superconducting wires (10, 12) forming part of the switch are the ends of the coils.

24. A superconducting magnet structure according to claim 22 or claim 23 wherein the switch is provided within the cryostat and a control arrangement for controlling the opening and closing of the switch is provided and is controllable from outside the cryostat.

25. A superconducting magnet structure according to any of claims 22-24 wherein the mechanical superconducting switch is arranged to be cooled by a same cooling arrangement used to cool the magnet.

## Patentansprüche

1. Mechanisch arbeitender supraleitender Schalter mit zwei supraleitenden Drähten (10, 12), bei denen jeweils ein Ende in einen jeweiligen Block (13, 14; 42, 52) aus supraleitendem Material gegossen ist, und einer mechanischen Anordnung (24, 16, 18, 20; 60) zum Bewegen jeweiliger Kontaktflächen (15) der beiden Blöcke in physischen Kontakt miteinander und zum Trennen der Flächen.

2. Mechanisch arbeitender supraleitender Schalter nach Anspruch 1, bei dem die supraleitenden Drähte Enden von Spulen sind, die einen supraleitenden Magneten bilden.

3. Mechanisch arbeitender supraleitender Schalter nach Anspruch 1, bei dem die mechanische Anordnung für einen Linearantrieb zum Bewegen der beiden Blöcke in mechanischen Kontakt miteinander und zum Trennen der Blöcke sorgt.

4. Mechanisch arbeitender supraleitender Schalter nach Anspruch 1, bei dem die mechanische Anordnung für einen Drehantrieb zum Bewegen der beiden Blöcke in mechanischen Kontakt miteinander und zum Trennen der Blöcke sorgt.

5. Mechanisch arbeitender supraleitender Schalter nach einem der vorhergehenden Ansprüche, bei dem zumindest einer der Blöcke unter Verwendung eines Gießverfahrens gebildet ist, bei dem ein entsprechender supraleitender Draht in einen Block aus supraleitendem Material gegossen wird, wobei das supraleitende Material des mindestens einen Blocks eine höhere Duktilität aufweist als das supraleitende Material des supraleitenden Drahtes.

6. Mechanisch arbeitender supraleitender Schalter nach einem der vorhergehenden Ansprüche, bei dem komplementäre Vorsprünge und Vertiefungen an entsprechenden Kontaktflächen (15) vorgesehen sind.

7. Mechanisch arbeitender supraleitender Schalter nach einem der vorhergehenden Ansprüche, bei dem mindestens einer der Blöcke Partikel oder Kügelchen (140) aus einem supraleitenden Material mit einer größeren Härte als das Material des entsprechenden Blocks enthält.

8. Mechanisch arbeitender supraleitender Schalter nach einem der vorhergehenden Ansprüche, der ferner mit einer Steueranordnung zum Steuern des Öffnens und Schließens des Schalters versehen ist.

9. Mechanisch arbeitender supraleitender Schalter nach Anspruch 3, bei dem ein oberes (16) und ein unteres (18) Gehäuseteil jeweilige Blöcke halten und ein Balg (20) das obere und das untere Gehäuseteil verbindet, so dass ein dichtes Gehäuse (22) von variabler Höhe entsteht.

10. Mechanisch arbeitender supraleitender Schalter nach Anspruch 9, bei dem ein elektrischer Isolator (22) bereitgestellt ist, der einen Bestandteil des Gehäuses bildet und elektrische Leitfähigkeit zwischen den Drähten (10, 12) durch das Material des Gehäuses verhindert.

11. Mechanisch arbeitender supraleitender Schalter nach Anspruch 4, bei dem:
- ein erster (42) der Blöcke eine im Wesentlichen zylinderförmige Wand (44) mit einem im Wesentlichen zylinderförmigen Hohlraum (46) darin aufweist und mindestens ein Vorsprung (48) an einer Wand in dem Hohlraum vorgesehen ist,
- ein zweiter (52) der Blöcke eine im Wesentlichen zylinderförmige Wand (54) aufweist und mindestens ein Vorsprung (58) an der Wand vorgesehen ist,
- sich der zweite Block zumindest teilweise in dem Hohlraum des ersten Blocks befindet, so dass sich entsprechende Vorsprünge (48; 58) in Umfangsrichtung überlappen, und
- die mechanische Anordnung Mittel (60) zum Drehen eines Blocks (42; 52) in Bezug auf den anderen um eine Achse (62) umfasst, die mit den Achsen der zylinderförmigen Wände des ersten und des zweiten Blocks in einer Linie liegt.

12. Mechanisch arbeitender supraleitender Schalter nach Anspruch 11, bei dem der erste Block (42) eine Anzahl Vorsprünge (48) aufweist, die der Anzahl Vorsprünge (58) an dem zweiten Block entspricht.

13. Mechanisch arbeitender supraleitender Schalter nach Anspruch 11 oder 12, bei dem bestimmte Flächen der Vorsprünge eines oder beider Blöcke (42, 52) mit einer elektrisch isolierenden Schicht bedeckt sind.

14. Mechanisch arbeitender supraleitender Schalter nach einem der Ansprüche 11 bis 13, bei dem die Vorsprünge (48; 58) parallel zur Achse (62) verlaufen.

15. Mechanisch arbeitender supraleitender Schalter nach einem der Ansprüche 11 bis 13, bei dem die Vorsprünge als komplementäre Gewindeflächen einer spiral- oder kegelförmigen Schraube ausgebildet sind.

16. Mechanisch arbeitender supraleitender Schalter nach Anspruch 15, bei dem die Gewindeflächen segmentiert sind.

17. Mechanisch arbeitender supraleitender Schalter nach einem der vorhergehenden Ansprüche, der um die Blöcke herum mit einem Vakuum oder einer inerten Atmosphäre versehen ist.

18. Mechanisch arbeitender supraleitender Schalter nach einem der vorhergehenden Ansprüche, bei dem Anordnungen für einen zusätzlichen mechanischen Antrieb der Blöcke im Gebrauch in Form von Vibrationen vorgesehen sind.

19. Mechanisch arbeitender supraleitender Schalter nach Anspruch 4, bei dem:
- ein erster (84; 94) der Blöcke einen Hohlraum (86; 96) darin aufweist,
- sich ein zweiter (80; 90) der Blöcke zumindest teilweise in dem Hohlraum des ersten Blocks befindet und so angeordnet ist, dass er sich in dem Hohlraum um eine Achse (82; 92) dreht, und
- die mechanische Anordnung Mittel zum Drehen eines Blocks (80; 90) in Bezug auf den anderen um die Achse umfasst.

20. Mechanisch arbeitender supraleitender Schalter mit zwei supraleitenden Drähten (10, 12), bei denen jeweils ein Ende in einen jeweiligen Block (102, 104) aus supraleitendem Material gegossen ist, wobei die Blöcke (102, 104) im Gebrauch in Bezug aufeinander stationär bleiben und eine supraleitende Gewindehülse (106) die beiden Blöcke durch relatives Drehen in und außer Kontakt bringt.

21. Mechanisch arbeitender supraleitender Schalter nach Anspruch 20, bei dem eine elektrisch isolierende Verlängerung (108) der supraleitenden Gewindehülse vorgesehen ist, so dass eine mechanische Ausrichtung der Blöcke (102, 104) gewährleistet ist, wenn die Hülse so gedreht wird, dass sie aus dem elektrischen Kontakt zwischen den Blöcken gebracht wird.

22. Supraleitende Magnetstruktur mit mehreren Spulen aus supraleitendem Draht, die elektrisch in Reihe geschaltet und in einem Kryostaten untergebracht sind, der zum Kühlen der Spulen angeordnet ist, **dadurch gekennzeichnet, dass** supraleitende Drähte von den elektrischen Enden der Spulen mit einem Schalter nach einem der vorhergehenden Ansprüche verbunden sind.

23. Supraleitende Magnetstruktur nach Anspruch 22, bei der es sich bei den supraleitenden Drähten (10, 12), die einen Bestandteil des Schalters bilden, um die Enden der Spulen handelt.

24. Supraleitende Magnetstruktur nach Anspruch 22 oder 23, bei der der Schalter in dem Kryostaten bereitgestellt ist und eine Steueranordnung zum Steuern des Öffnens und Schließens des Schalters bereitgestellt ist und sich von außerhalb des Kryostaten steuern lässt.

25. Supraleitende Magnetstruktur nach einem der Ansprüche 22 bis 24, bei der der mechanische supraleitende Schalter so angeordnet ist, dass er von der gleichen Kühlanordnung gekühlt wird wie der Magnet.

## Revendications

1. Commutateur supraconducteur à commande mécanique comprenant deux fils supraconducteurs (10, 12), une extrémité respective de chaque fil supraconducteur étant coulée dans un bloc respectif (13, 14 ; 42, 52) de matériau supraconducteur, et un agencement mécanique (24, 16, 18, 20 ; 60) permettant de mettre des surfaces de contact (15) respectives des deux blocs en contact physique l'une avec l'autre, et à les séparer.

2. Commutateur supraconducteur à commande mécanique selon la revendication 1 dans lequel les fils supraconducteurs sont des extrémités de bobines formant un aimant supraconducteur.

3. Commutateur supraconducteur à commande mécanique selon la revendication 1 dans lequel l'agencement mécanique assure un actionnement linéaire permettant d'amener les deux blocs en contact mécanique l'un avec l'autre et de les séparer.

4. Commutateur supraconducteur à commande mécanique selon la revendication 1 dans lequel l'agencement mécanique assure un actionnement rotatif permettant d'amener les deux blocs en contact mécanique l'un avec l'autre et de les séparer.

5. Commutateur supraconducteur à commande mécanique selon l'une quelconque des revendications précédentes, dans lequel on forme au moins l'un des blocs en utilisant un procédé de coulage dans lequel un fil supraconducteur correspondant est coulé dans un bloc de matériau supraconducteur, le matériau supraconducteur du au moins un bloc ayant une ductilité plus grande qu'une ductilité du matériau supraconducteur du fil supraconducteur.

6. Commutateur supraconducteur à commande mécanique selon l'une quelconque des revendications précédentes, dans lequel des saillies et des creux complémentaires sont aménagés sur des surfaces de contact (15) respectives.

7. Commutateur supraconducteur à commande mécanique selon l'une quelconque des revendications précédentes, dans lequel au moins l'un des blocs contient des particules ou perles (140) d'un matériau supraconducteur ayant une dureté plus grande qu'une dureté du matériau du bloc correspondant.

8. Commutateur supraconducteur à commande mécanique selon l'une quelconque des revendications précédentes, par ailleurs pourvu d'un agencement de commande permettant de commander l'ouverture et la fermeture du commutateur.

9. Commutateur supraconducteur à commande mécanique selon la revendication 3, dans lequel des pièces de boîtier supérieure (16) et inférieure (18) retiennent les blocs respectifs et dans lequel un soufflet (20) relie les pièces de boîtier supérieure et inférieure pour réaliser un boîtier hermétique (22) de hauteur variable.

10. Commutateur supraconducteur à commande mécanique selon la revendication 9, dans lequel on prévoit un isolant électrique (22), faisant partie du boîtier, pour empêcher la conduction électrique entre les fils (10, 12) à travers le matériau du boîtier.

11. Commutateur supraconducteur à commande mécanique selon la revendication 4, dans lequel
- un premier bloc (42) parmi lesdits blocs comporte une paroi essentiellement cylindrique (44), une cavité essentiellement cylindrique (46) y étant contenue, et au moins une saillie (48) est aménagée sur une paroi de la cavité ;
- un second bloc (52) parmi lesdits blocs comporte une paroi essentiellement cylindrique (54) et au moins une saillie (58) est aménagée sur la paroi ;
- le second bloc est au moins partiellement situé dans la cavité du premier bloc de sorte que les saillies respectives (48 ; 58) se chevauchent dans un sens circonférentiel, et
- l'agencement mécanique comprend des moyens (60) permettant de faire tourner un bloc (42 ; 52) par rapport à l'autre autour d'un axe (62) aligné sur les axes des parois cylindriques du premier et du second bloc.

12. Commutateur supraconducteur à commande mécanique selon la revendication 11, dans lequel le premier bloc (42) comporte un nombre de saillies (48) égal au nombre de saillies (58) du second bloc.

13. Commutateur supraconducteur à commande mécanique selon la revendication 11 ou la revendication 12, dans lequel certaines faces des saillies de l'un des blocs (42, 52) ou des deux sont recouvertes d'une couche électriquement isolante.

14. Commutateur supraconducteur à commande mécanique selon l'une quelconque des revendications 11-13, dans lequel les saillies (48 ; 58) courent parallèlement à l'axe (62).

15. Commutateur supraconducteur à commande mécanique selon l'une quelconque des revendications 11-13, dans lequel les saillies sont réalisées sous la forme de surfaces filetées complémentaires d'une vis hélicoïdale ou conique.

16. Commutateur supraconducteur à commande mécanique selon la revendication 15, dans lequel les surfaces filetées sont segmentées.

17. Commutateur supraconducteur à commande mécanique selon l'une quelconque des revendications précédentes, doté d'un vide ou d'une atmosphère inerte autour des blocs.

18. Commutateur supraconducteur à commande mécanique selon l'une quelconque des revendications précédentes, dans lequel des agencements sont prévus pour réaliser en service un actionnement mécanique additionnel des blocs, sous la forme de vibration.

19. Commutateur supraconducteur à commande mécanique selon la revendication 4, dans lequel :
- un premier bloc (84 ; 94) parmi lesdits blocs comporte une cavité (86 ; 96) y contenue ;
- un second bloc (80 ; 90) parmi lesdits blocs est au moins partiellement situé à l'intérieur de la cavité du premier bloc, agencé pour tourner à l'intérieur de la cavité autour d'un axe (82 ; 92), et
- l'agencement mécanique comprend des moyens pour faire tourner un bloc (80 ; 90) par rapport à l'autre autour de l'axe.

20. Commutateur supraconducteur à commande mécanique comprenant deux fils supraconducteurs (10, 12), une extrémité respective de chaque fil supraconducteur étant coulée dans un bloc (102, 104) respectif de matériau supraconducteur, étant entendu qu'en service, les blocs (102, 104) restent stationnaires l'un par rapport à l'autre et qu'un collier supraconducteur fileté (106) est amené en et hors contact entre les deux blocs par rotation relative.

21. Commutateur supraconducteur à commande mécanique selon la revendication 20 dans lequel un prolongement électriquement isolant (108) du collier supraconducteur fileté est aménagé de sorte que l'alignement mécanique des blocs (102, 104) soit assuré lorsque le collier est amené par rotation hors contact électrique entre les blocs.

22. Structure d'aimant supraconducteur comprenant une pluralité de bobines de fil supraconducteur montées en série électriquement, logées dans un cryostat agencé pour refroidir les bobines, **caractérisée en ce que** les fils supraconducteurs sortant des extrémités électriques des bobines sont reliés à un commutateur selon l'une quelconque des revendications précédentes.

23. Structure d'aimant supraconducteur selon la revendication 22, dans laquelle les fils supraconducteurs (10, 12) faisant partie du commutateur sont les extrémités des bobines.

24. Structure d'aimant supraconducteur selon la revendication 22 ou la revendication 23 dans laquelle le commutateur est prévu à l'intérieur du cryostat et dans lequel un agencement de commande permettant de commander l'ouverture et la fermeture du commutateur est prévu et peut être manoeuvré de l'extérieur du cryostat.

25. Structure d'aimant supraconducteur selon l'une quelconque des revendications 22-24 dans laquelle le commutateur supraconducteur mécanique est agencé pour être refroidi par un agencement refroidisseur identique à celui utilisé pour refroidir l'aimant.
